# EUROPEAN PATENT SPECIFICATION

(11) **EP 0 333 382 B1**
(45) Date of publication and mention of the grant of the patent: **29.09.1993**
(21) Application number: 89302365.5
(22) Date of filing: 10.03.1989
(51) Int. Cl.: G01R 23/02

(54) **Frequency detection**
Frequenzbestimmung
Détection de fréquence

(30) Priority: 14.03.1988 JP 59974/88
(43) Date of publication of application: 20.09.1989
(73) Proprietor: SONY CORPORATION, Tokyo 141 (JP)
(72) Inventor: Ando, Naotaka c/o Patents Division, Shinagawa-ku Tokyo 141 (JP)
(74) Representative: Pilch, Adam John Michael

(56) References cited:
- DE-A- 2 850 082
- DE-A- 3 007 657
- US-A- 4 025 868
- US-A- 4 144 489
- US-A- 4 611 926

## Description

This invention relates to frequency detection, and in particular to frequency detectors and to methods of detecting frequencies.

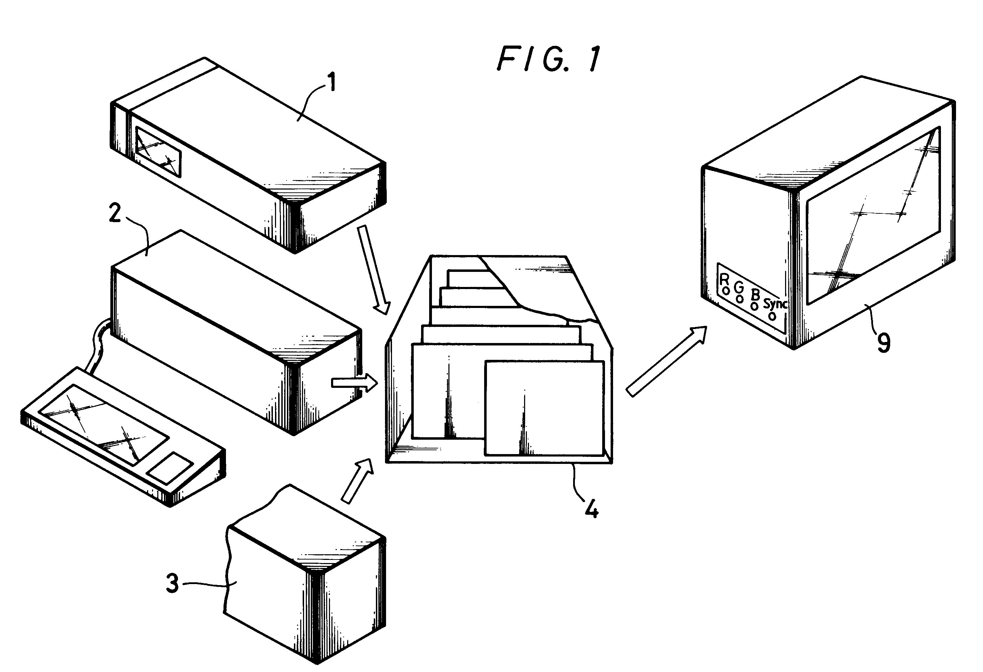

Computers with various functions have recently been developed and widely used, but horizontal synchronising signals of video signals delivered from these computers have not yet been standardised. Therefore, a scanning-converter apparatus is required to enable a single monitor to check or monitor various input video signals having various horizontal frequencies. The present applicants have previously proposed a scanning-converter apparatus that can be used in a monitor system as shown in Figure 1 of the accompanying drawings. This previously-proposed scanning-converter apparatus is disclosed in Japanese Patent Application No. 61-250 592, published on 10.5.88 as JP-A-63104585 and on 16.5.89 as US-A-4831441.

Figure 1 illustrates in diagrammatic form a monitor system that includes a television tuner 1, a high density personal computer 2 and another computer 3. The television tuner 1 produces a video signal having a horizontal frequency fH1 selected to be 15.75 kHz, the personal computer 2 produces a video signal having a horizontal frequency fH2 selected to be 24 kHz, and the computer 3 produces a video signal having a horizontal frequency fH3 selected to be 27.15 kHz. These video signals are supplied to a scanning-converter apparatus 4 in which they are converted into a video signal having a horizontal frequency of 63.35 kHz, which is fed to a monitor 9 whose horizontal deflection frequency fH is 63.35 kHz.

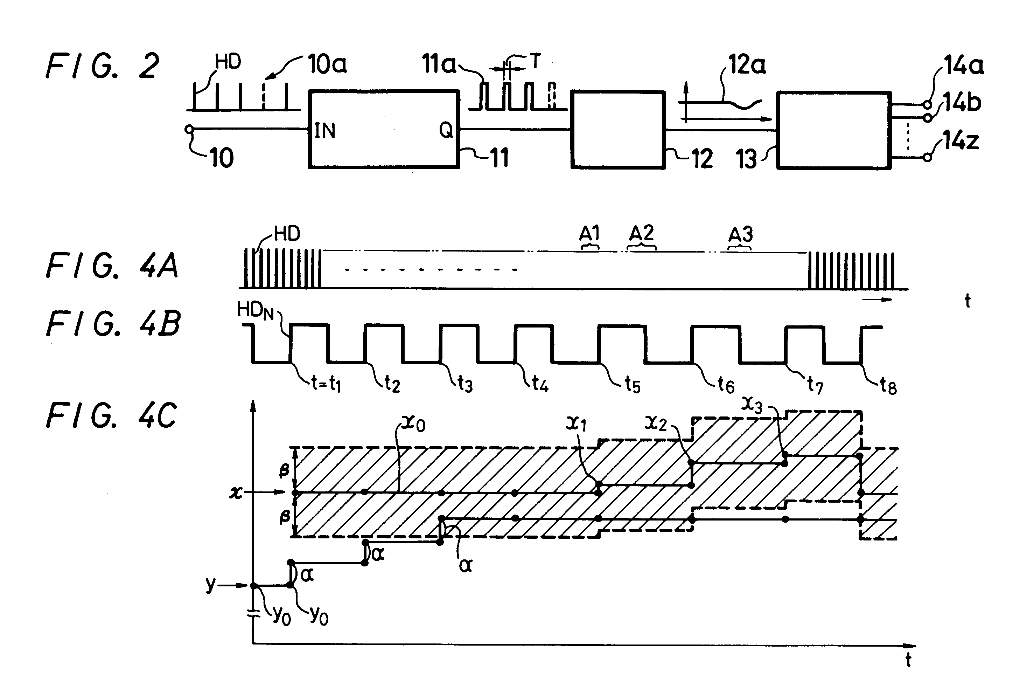

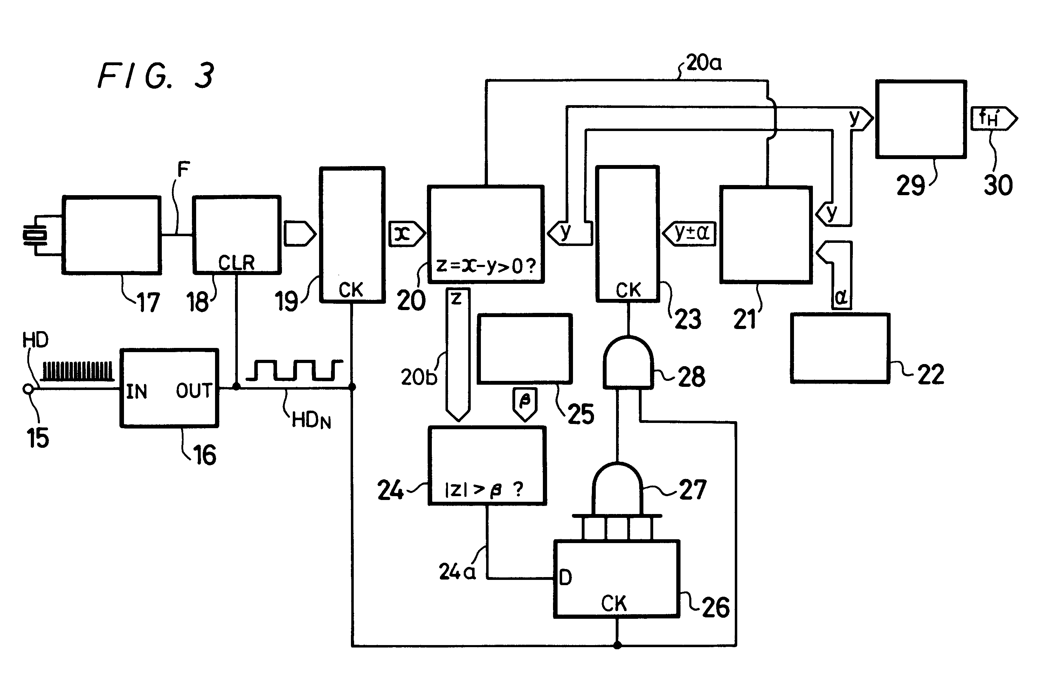

When the incoming video signal from, for example, the computer 3 is received and reproduced by the monitor 9, seven horizontal scanning lines of the output video signal from the scanning-converter apparatus 4 have to be provided corresponding to three horizontal scanning lines of the input video signal to the scanning-converter apparatus 4, because the ratio between the horizontal frequency fH3 of the incoming video signal from the computer 3 to the horizontal deflection frequency fH of the monitor 9 is
fH3 : fH = 27.15 kHz : 63.35 kHz = 3 : 7
Accordingly, an interpolation computation must be carried out in order to obtain a sufficiently smooth and natural looking output picture image. The coefficient used in the interpolation computation depends on the horizontal frequency of the input video signal, so it is necessary to provide a circuit that can accurately detect the horizontal frequency of the input video signal. The circuit illustrated in Figure 2 of the accompanying drawings is representative of a frequency detector that has been proposed for this purpose.

As shown in Figure 2, a horizontal synchronising signal HD of the input video signal is supplied to an input terminal 10. The horizontal synchronising signal HD has a frequency of fH. The input terminal 10 is connected to an input terminal IN of a monostable multivibrator 11 so that, in response to each leading edge of the horizontal synchronising signal HD, the monostable multivibrator 11 produces at its output terminal Q a pulse train 11a of a predetermined pulse width T. This pulse train 11a is converted into a direct current signal 12a by a low-pass filter (LPF) 12 and is then fed to a level detector 13. The level detector 13 is composed of a plurality of comparators (not shown) having different comparison or reference levels, and only a comparator with a reference level higher than the level of the direct current signal 12a produces an output of a high level "1". The output signal is directly supplied to output terminals 14a, 14b, ... 14z. When the horizontal frequency fH of the horizontal synchronising signal HD is increased and its pulse interval is reduced, the value of the direct current signal 12a, which is the output signal from the low-pass filter 12, is increased so that the frequency fH of the horizontal synchronising signal HD can be identified stepwise by detecting which of the output terminals 14a to 14z produces an output signal of the high level "1".

In the frequency detector as described above, however, a constant number of the output pulses 11a of the monostable multivibrator 11 is required, and when the frequency of the horizontal synchronising signal HD constituting the signal to be measured is increased beyond a certain point, the pulses in the pulse train 11a from the monostable multivibrator 11 overlap one another, causing a detection error.

Particularly when an incoming video signal is derived from a cassette-type video tape recorder (VTR) or the like, it is frequently observed that a fluctuation or jitter of pulses exists in the time base of the horizontal synchronising signal HD or a pulse dropout 10a occurs therein as shown in Figure 2. This jitter or pulse dropout is directly detected as a detection level change by the previously-proposed frequency detector, so that the detected value becomes inaccurate and unstable. If such a detected value is used for signal processing, a deleterious influence will be exerted upon a peripheral circuit in which the detected value is used.

DE-A-2 850 082 discloses circuitry for testing whether successive cycles of a periodic signal fall within stipulated timing tolerances. When a settable number of successive cycles pass this test, the following cycles are accepted and stored to provide the sought estimate of the signal's period.

US-A-4 144 489 discloses a digital phase locked loop providing a binary output indicative of the frequency of a reference signal which is locked to an input signal.

According to one aspect of the present invention there is provided a frequency detector comprising:
means for producing a cyclical reference clock signal;
means for receiving an input signal having a frequency to be measured;
a counter for counting cycles of said reference clock signal repetitively during successive intervals of time derived from said input signal;
means for establishing a setting cycle; and
a computing circuit connected to said counter and to said means for establishing a setting cycle for adding or subtracting a first constant to or from said setting cycle in response to a difference between a count value of said counter and said setting cycle;
wherein, when said difference between said count value of said counter and said setting cycle exceeds a second constant during a predetermined number of said successive intervals, said setting cycle is adjusted by an output from said computing circuit and an approximate value of a cycle of said input signal is computed, thereby detecting the approximate frequency of said input signal.

According to another aspect of the present invention there is provided a method of detecting a frequency of a pulsed input signal, the method comprising the steps of:
producing a reference clock signal of a given frequency;
receiving said pulsed input signal and dividing said received pulsed signal by N to produce an N-divided output signal;
counting cycles of said reference clock signal during successive cycles of said N-divided output signal;
latching the value of the cycles of said reference clock signal counted during said successive cycles of said N-divided output signal;
establishing a setting cycle;
comparing a latched value of the cycles counted and said setting cycle;
adding or subtracting a first constant to or from said setting cycle in response to a difference between said latched value of the cycles counted and said setting cycle;
adjusting said setting cycle in accordance with said adding or subtracting when the difference between said latched value and said setting cycle exceeds a second constant during a predetermined number of said successive cycles of said N-divided output signal, thereby determining an approximate value of the period of the pulsed input signal; and
determining the approximate frequency on the basis of the determined period.

A preferred embodiment of the present invention, to be described in greater detail hereinafter, provides an apparatus for detecting the frequency of an input signal suitable for use with a digital scanning-converter. The preferred frequency detector can stably detect the frequency of a signal to be measured with high accuracy over a wide range even when the frequency is changed, and can stably detect the frequency regardless of the occurrence of a pulse dropout in the signal to be measured.

The invention will now be described by way of example with reference to the accompanying drawings, throughout which like parts are referred to by like references, and in which:
Figure 1 is a partial cut-away perspective view illustrating an example of a monitor system utilising a scan converter apparatus;
Figure 2 is a block diagram of a previously-proposed frequency detector;
Figure 3 is a block diagram of a frequency detector constructed in accordance with an embodiment of the present invention; and
Figures 4A to 4C are diagrams used to explain a process of frequency detection in the embodiment shown in Figure 3.

A frequency detector embodying the present invention comprises, as shown for example in Figure 3, a counter 18 for counting a reference clock F during an N-divided period of a horizontal synchronising signal HD serving as a signal to be measured and an adding/subtracting circuit 21 for adding or subtracting (only under the condition described below) a first constant α to or from a setting cycle y in response to a level difference between a count value x of the counter 18 and the setting cycle y. In particular, when the difference between the count value x of the counter 18 and the setting cycle y exceeds a second constant β, an approximate value of a period TH of the horizontal synchronising signal HD is obtained while changing the setting cycle Y by ± α to produce an output value y ± α . This process is repeated as necessary to enable detection of the period and therefore the frequency fH of the horizontal synchronising signal HD.

According to the present embodiment, as set forth above, if the frequency of the reference clock F is taken as fCK and the period of the horizontal synchronising signal HD is taken as TH, the count value x of the reference clock F during the N-divided period of the horizontal synchronising signal HD is expressed as:

$\text{x = N.TH.fCK (1)}$

Until the difference between the count value x and the setting cycle y becomes less than the second constant β , the first constant α is added to or subtracted from the setting cycle y. Therefore, in the case of an error ± β as shown in Figure 4C, there is obtained from equation (1) the following equation:

$\text{y ∼ x = N.TH.fCK (2)}$

Since x, N and fCK are already known, an approximate value of the period TH of the horizontal synchronising signal HD can be calculated from equation (2). Further, since the frequency fH of the horizontal synchronising signal HD is the reciprocal of the period TH, the frequency fH can be obtained directly from the period TH.

If a pulse dropout occurs in the horizontal synchronising signal HD, the setting value y is not changed as long as the difference between the count value x and the setting value y is less than ± β . A stable detected value of the frequency fH is thus reliably obtained in spite of possible dropouts of the signal to be detected.

A frequency detector constructed in accordance with a preferred embodiment of the present invention will now be described with reference to the drawings.

The block diagram forming Figure 3 shows in detail the preferred embodiment. An input terminal 15 is supplied with the horizontal synchronising signal HD of frequency fH and period TH. The frequency fH of the horizontal synchronising signal HD generally falls within a range between 15 kHz and 130 kHz. The input terminal 15 is connected to an input terminal IN of a divide-by-N frequency divider 16, hereinafter referred to as an N frequency divider. The N frequency divider 16 produces at its output terminal OUT a signal HDN which results from dividing the horizontal synchronising signal HD by N. In the preferred embodiment, N = 128.

An oscillator 17 produces a reference clock F having a frequency fCK. The reference clock F is supplied to a trigger terminal of the counter 18. The count value of the counter 18 is supplied to an input terminal of a latch circuit 19, and the N-divided signal HDN is supplied to the clear terminal CLR of the counter 18 and the clock terminal CK of the latch circuit 19. Accordingly, a value x held at the output terminal of the latch circuit 19 indicates the number of pulses of the reference clock F counted during every N cycles of the horizontal synchronising signal HD. The value x is expressed by the following equation:

$\text{x = N.TH/(1/fCK) = N.TH.fCK (3)}$

Thus, x is sometimes referred to hereinafter as a cycle count value.

The cycle count value x is supplied to one input terminal of a computing and comparing circuit 20, while the computing and comparing circuit 20 receives at its other input terminal a setting cycle y which homes-in on the value of x in one or more iterations as will be explained in more detail later. The computing and comparing circuit 20, on the basis of the cycle count value x and the setting cycle y received as inputs, calculates an error value z that is defined as:

$\text{z = x - y (4)}$

and supplies the same as an error signal to an output signal line 20b. At the same time, the circuit 20 supplies a compared signal 20a corresponding to the positive or negative polarity of the error value z to the adding/subtracting circuit 21. The compared signal 20a is set at a high level "1" when the error value z, for example, is positive or zero, while it is set a low level "0" when the error value z is negative.

The add/subtracting circuit 21 is supplied at one of its input terminals with the setting cycle y and at the other of its input terminals with a constant α that is set by a setting circuit 22. In general, the frequency fH of the horizontal synchronising signal HD is selected to be about 20 kHz (period of 0.05 ms) so that, if T0 = 0.05 ms, the constant α is selected so as to satisfy the following equation:

$\text{α = N.T0.fCK/512 (5)}$

The adding/subtracting circuit 21 produces, when the compared signal 20a is at the high level "1", or an inequality $\text{x - y ≧ 0}$ is established, an output of y + α , while it produces, when the compared signal 20a is at the low level "0", or an inequality $\text{x - y < 0}$ is established, an output of y - α . The output value y ± α from the adding/subtracting circuit 21 is supplied to an input terminal of a latch circuit 23 which latches to this value as the updated value of y.

The error z, which is the output value of the computing and comparing circuit 20, is supplied to one input terminal of a comparing circuit 24, and the comparing circuit 24 is supplied at its other input terminal with an output value β from a setting circuit 25. The comparing circuit 24 supplies a compared signal 24a to a data terminal D of an M-bit shift register 26. The compared signal 24a goes to a high level "1" when | z | > β is established, while it goes to a low level "0" when | z | ≦ β. In the preferred embodment of the invention, the value β is set so as to satisfy the following equation:

$\text{β = N.T0.fCK/256 = 2α (6)}$

Generally, the value β is selected to be such that the value α becomes smaller than 2β or even, as Figure 4C shows, smaller than β .

In this embodiment, the bit capacity M of the M-bit shift register 26 is selected to be a plurality such as four (M = 4), and the four-bit output signals from the shift register 26 are supplied to input terminals of a four-input AND gate 27. The output signal from the four-input AND gate 27 is supplied to one input terminal of an AND gate 28, and the N-divided signal HDN is supplied to the other input terminal of the AND gate 28 and to the clock terminal CK of the M-bit shift register 26. The output signal from the AND gate 28 is supplied to the clock terminal CK of the latch circuit 23 so that, if the N-divided signal HDN rises when the four-bit output signal of the M-bit shift register 26 is at the high level "1" and the output of the AND gate 27 is therefore also high, the setting cycle y, which is the output value of the latch circuit 23, is changed to the output value y ± α of the adding/subtracting circuit 21.

The latch circuit 23 acts to set the setting cycle y, when the power switch is turned ON, at N.T0.fCK by using the cycle or period T0 where the frequency is 20 kHz. Therefore, this value of y is referred to as the initial setting cycle or period. Since the output of the M-bit shift register 26 goes to a high level as long as the compared signal 24a is at a high level, the setting cycle y is adjusted to a value of y ± α at the leading edge of the N-divided signal HDN, and thus the setting cycle y approaches the cycle count value x. When the compared signal 24a finally goes to a low level "0", or the relationship

$\text{| z | = | x - y | ≦ β (7)}$

is established, the output signal from the four-input AND gate 27 goes to a low level so that the setting cycle y as the output value of the latch circuit 23 is not further adjusted. Accordingly, since the setting cycle y is fixed near the cycle count value x within the error ± β , from equations (3) and (6), there is obtained the following inequality

$\text{| N.TH.fCK - y | ≦ N.T0.fCK/256}$

From this it follows that the inequality 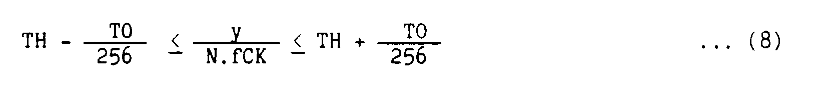
is established. Since N and fCK are already known, the cycle TH of the horizontal synchronising signal HD is calculated from the value of the setting cycle y within the error of ± T0/256.

This setting cycle y is supplied to a computing circuit 29, and the computing circuit 29 computes a detecting frequency fH of the horizontal synchronising signal HD on the basis of the following equation:

$\text{fH′= N.fCK/y (9)}$

If Δf is taken to be the maximum error of the detecting frequency fH′, then, from equation (8), Δf can be expressed by the following equation: 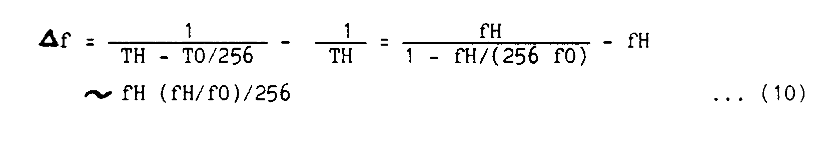
The maximum error Δf when the frequency fH of the horizontal synchronising signal HD is f0 (20 kHz) becomes about 0.1 kHz.

The operation of this embodment until the setting cycle y is stabilised in the frequency detector is as follows. Let it be assumed that the cycle or period TH of the horizontal synchronising signal HD is longer than the cycle or period T0, that the horizontal synchronising signal HD and its N-divided counterpart signal HDN are presented as shown in Figures 4A and 4B, respectively, and that all bits of the output from the M-bit shift register 26 in Figure 3 are set at a high level "1". The hatched area of Figure 4C is the area in which the error of the cycle count value x lies within ± β.

At this time, the value of the setting cycle y when the power switch is turned ON is set at $\text{y₀ (= N.T0.fCK)}$ 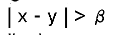 . At a time t1 at which the N-divided signal HDN rises, since TH > T0 is established as indicated above, the inequality x > y is established and the setting value y is adjusted to y₀ + α (see Figure 4C). Similarly, at times t2 and t3 where the N-divided signal HDN respectively rises, the setting value y is adjusted to y + α. In this case, the setting value y which is changed at the time t3 satisfies the relationship $\text{x - y < β}$ so that the compared signal 24a of the comparing circuit 24 in Figure 3 goes to a low level. Accordingly, at the next time t4 in which the N-divided signal HDN rises, the value held in the latch circuit 23 in Figure 3 is not updated. As a result, as Figure 4C shows, the setting cycle y is not adjusted. Further, if there is a pulse dropout A1 in the horizontal synchronising signal HD as shown in Figure 4A, the cycle count value x at a time t5 at which the N-divided signal HDN rises is changed to x1. In this case, however, the relationship expressed by the inequality $\text{x - y ≦ β}$ is satisfied so that the setting cycle y at a time t6 at which the N-divided signal HDN rises next is not changed at all.

If there is a large pulse dropout A2 in the horizontal synchronising signal HD (see Figure 4A) before a time t6, the value of the cycle count value x is changed to x2, satisfying the relationship $\text{x - y > β}$ . Thus, the compared signal 24a of the comparing circuit 24 in Figure 3 goes to a high level. However, at the times t4, t5 and t6, data of three bits at a low level are stored in the M-bit shift register 26 so that at a time t7 at which the N-divided signal HDN rises next, the output signal from the AND gate 28 shown in Figure 3 stays at a low level. Thus, again in this case, the setting cycle y is not changed at all. Further, even if there is a large pulse dropout A3 in the horizontal synchronising signal HD between the times t6 and t7 as shown in Figure 4A and the cycle count value x is changed to x3, the output from the AND gate 28 shown in Figure 3 stays at a low level, thus inhibiting the setting cycle y from being adjusted at a time t8 at which the N-divided signal HDN rises. Therefore, the detecting frequency fH calculated on the basis of the equation (9) is stable even in the presence of dropouts.

In this embodiment, since a four-bit shift register is used as the M-bit shift register 26 in Figure 3, the value of the setting cycle y is not adjusted as long as the condition expressed by the inequality $\text{| x - y | > β}$ does not occur four times consecutively at the leading edge of the N-divided signal HDN. Accordingly, even if pulse dropouts occur in the horizontal synchronising signal HD in succession, the detecting frequency does not fluctuate and undesired switching, hunting or the like does not occur in the succeeding circuitry.

Since the error between the cycle count value x and the setting cycle y quickly settles within the constant β , the setting cycle y is not varied at all regardless of the fluctuation of the horizontal synchronising signal HD from a time base standpoint. Also, even when the frequency of the horizontal synchronising signal HD is increased, the frequency can be detected with accuracy substantially as described above.

In addition to detecting the frequency of the horizontal synchronising signal of the incoming video signal as described above, the frequency detector as described is effective in obtaining a stable frequency under the circumstance that the frequency of a signal to be measured fluctuates because of the occurrence of pulse dropouts, time base errors or the like.

A frequency detector constructed as described above can detect the frequency to be measured with high accuracy even if the signal may have any frequency within a wide range. Also, the frequency detector can stably detect the frequency regardless of the occurrence of pulse dropouts, time base variations or the like in the signal to be measured.

Modifications and variations of the above-described arrangement are possible; for example, the M-bit shift register need not be limited to four outputs, and the values of α and β can be adjusted as required.

## Claims

1. A frequency detector comprising:
means (17) for producing a cyclical reference clock signal (F);
means (15) for receiving an input signal (HD) having a frequency (fH) to be measured;
a counter (18) for counting cycles of said reference clock signal (F) repetitively during successive intervals of time derived from said input signal;
means (22) for establishing a setting cycle (y); and
a computing circuit (21) connected to said counter (18) and to said means (22) for establishing a setting cycle for adding or subtracting a first constant (α) to or from said setting cycle (y) in response to a difference (z) between a count value (x) of said counter (18) and said setting cycle (y);
wherein, when said difference (z) between said count value (x) of said counter (18) and said setting cycle (y) exceeds a second constant (β) during a predetermined number (M) of said successive intervals, said setting cycle (y) is adjusted by an output from said computing circuit (21) and an approximate value of a cycle of said input signal (HD) is computed, thereby detecting the approximate frequency (fH) of said input signal.

2. A frequency detector according to claim 1, wherein, when said difference (z) between said count value (x) and said setting cycle (y) does not exceed said second constant (β) continually during at least said predetermined number (M) of intervals, said setting cycle (y) is not adjusted, whereby protection is obtained against premature adjustment of said setting cycle (y) in response to dropouts or time base fluctuations occurring in said input signal (HD).

3. A frequency detector according to claim 2, wherein said predetermined number (M) of intervals is a plurality.

4. A frequency detector according to claim 3, wherein said predetermined number (M) of intervals is four.

5. A frequency detector according to claim 2, wherein:
said input signal (HD) is a pulsed input signal;
said means (15) for receiving said input signal (HD) comprises means for dividing said input signal (HD) by N to produce an N-divided output signal (HDN);
said successive intervals comprise respective successive cycles of said N-divided output signal (HDN), said counter being reset by successive cycles of said N-divided output signal (HDN);
said frequency detector comprises means (19) for latching the value of the cycles counted by said counter (18) during said successive cycles of said N-divided output signal (HDN), said computing circuit (21) being connected to said latching means, said count value (x) being the latched value of said counter (18); and
said computation of a cycle of said input signal comprises a computation of the period (TH) of said pulsed input signal.

6. A method of detecting a frequency (fH) of a pulsed input signal (HD), the method comprising the steps of:
producing a reference clock signal (F) of a given frequency (fCK);
receiving said pulsed input signal (HD) and dividing said received pulsed signal by N to produce an N-divided output signal (HDN);
counting cycles of said reference clock signal (F) during successive cycles of said N-divided output signal (HDN);
latching the value of the cycles of said reference clock signal (F) counted during said successive cycles of said N-divided output signal (HDN);
establishing a setting cycle (y);
comparing a latched value (x) of the cycles counted and said setting cycle (y);
adding or subtracting a first constant (α) to or from said setting cycle (y) in response to a difference (z) between said latched value (x) of the cycles counted and said setting cycle (y);
adjusting said setting cycle (y) in accordance with said adding or subtracting when the difference (z) between said latched value (x) and said setting cycle (y) exceeds a second constant (β) during a predetermined number (M) of said successive cycles of said N-divided output signal (HDN), thereby determining an approximate value of the period (TH) of the pulsed input signal (HD); and
determining the approximate frequency (fH) on the basis of the determined period (TH).

7. A method according to claim 6, comprising, when said difference (z) between said latched value (x) of the cycles counted and said setting cycle (y) does not exceed said second constant (β) continually during at least said predetermined number (M) of successive cycles of said N-divided output signal (HDN), the step of using a previous value of the frequency (fH) of the pulsed input signal (HD).

## Patentansprüche

1. Frequenzerfassungvorrichtung aufweisend:
eine Einrichtung (17) zur Erzeugung eines zyklischen Referenztaktsignals (F);
eine Einrichtung (15) zum Empfang eines Eingangssignals (HD) mit einer zu messenden Frequenz (fH);
einen Zähler (18), um die Zyklen des Referenztaktsignals (F) wiederholt während aufeinanderfolgender von dem Eingangssignal abgeleiteter Intervalle zu zählen;
eine Einrichtung (22) zur Erzeugung eines Einstellzyklus (y); und
eine mit dem Zähler und der Einrichtung zur Erzeugung eines Einstellzyklus verbundene Berechnungsschaltung (21), um eine erste Konstante (α) zu dem Einstellzyklus (y) zu addieren oder davon zu subtrahieren abhängig von einer Differenz (z) zwischen einem Zählwert (x) des Zählers (18) und dem Einstellzyklus (y);
wobei dann, wenn die Differenz (z) zwischen dem Zählerwert (x) des Zählers (18) und dem Einstellzyklus (y) während einer vorbestimmten Anzahl (M) aufeinanderfolgender Intervalle eine zweite Konstante (β) übersteigt, der Einstellzyklus (y) durch ein Ausgangssignal der Berechnungsschaltung (21) eingestellt wird und ein ungefährer Wert eines Zyklus des Eingangssignals (HD) berechnet wird, wobei die ungefähre Frequenz (fH) des Eingangssignals erfaßt wird.

2. Frequenzerfassungsvorrichtung nach Anspruch 1,
wobei, dann, wenn die Differenz (z) zwischen dem Zählwert (x) und dem Einstellzyklus (y) eine zweite Konstante (β) während wenigstens einer vorbestimmten Anzahl (M) von Intervallen nicht übersteigt, der Einstellzyklus (y) nicht eingestellt wird, wodurch ein Schutz gegen verfrühte Anpassung des Einstellzyklus (y) als Folge von Ausfällen oder Zeitbasisfluktuationen, die im Eingangssignal (HD) auftreten, erhalten wird.

3. Frequenzerfassungsvorrichtung nach Anspruch 2,
wobei die vorbestimmte Anzahl (M) der Intervalle eine Mehrzahl ist.

4. Frequenzerfassungsvorrichtung nach Anspruch 3,
wobei die vorbestimmte Anzahl (M) der Intervalle vier ist.

5. Frequenzerfassungsvorrichtung nach Anspruch 2,
wobei:
das Eingangssignal (HD) ein gepulstes Eingangssignal ist;
die Einrichtung (15) zum Empfang des Eingangssignals (HD) eine Einrichtung zur Division des Eingangssignals (HD) durch N aufweist, um ein durch N dividiertes Ausgangssignal (HDN) zu erzeugen;
die aufeinanderfolgenden Intervalle jeweils aufeinanderfolgende Zyklen des durch N dividierten Ausgangssignals (HDN) aufweisen und der Zähler durch aufeinanderfolgende Zyklen des durch N dividierten Ausgangssignals (HDN) rückgesetzt wird;
die Frequenzerfassungsvorrichtung eine Einrichtung (19) zur Verriegelung des Werts der durch den Zähler (18) während der aufeinanderfolgenden Zyklen des durch N dividierten Ausgangssignals (HDN) gezählten Zyklen aufweist, wobei die Berechnungsschaltung (21) mit der Verriegelungseinrichtung verbunden ist und der Zahlwert (x) der verriegelte Wert des Zählers (18) ist und
die Berechnung des Zyklus des Eingangssignals eine Berechnung der Periode (TH) des gepulsten Eingangssignals enthält.

6. Verfahren zur Bestimmung einer Frequenz (fH) eines gepulsten Eingangssignals (HD), mit den Verfahrensschritten:
Erzeugen eines Referenztaktsignals (F) einer gegebenen Frequenz (fCK);
Empfangen eines gepulsten Eingangssignals (HD) und Dividieren des empfangenen gepulsten Signals durch (N), um ein durch N dividiertes Ausgangssignal (HDN) zu erzeugen;
Zählen der Zyklen des Referenztaktsignals (F) während aufeinanderfolgender Zyklen des durch N dividierten Ausgangssignals (HDN);
Verriegeln des Wertes der Zyklen des Referenztaktsignals (F), die während der aufeinanderfolgenden Zyklen des durch N dividierten Ausgangssignals (HDN) gezählt wurden;
Erzeugen eines Einstellzyklus (y);
Vergleichen des verriegelten Wertes (x) der gezählten Zyklen mit dem Einstellzyklus (y),
Addieren oder Subtrahieren einer ersten Konstante (α) zu bzw. von dem Einstellzyklus (y) abhängig von einer Differenz (z) zwischen dem verriegelten Wert (x) der gezählten Zyklen des Einstellzyklus (y);
Einstellen des Einstellzyklus (y) in Übereinstimmung mit der Addition oder der Subtraktion, wenn die Differenz (z) zwischen dem festgehaltenen Wert (x) und dem Einstellzyklus (y) eine zweite Konstante (β) während einer vorbestimmten Anzahl (M) aufeinanderfolgender Zyklen des durch N dividierten Ausgangssignals (HDN) übersteigt, wobei ein ungefährer Wert der Periode (TH) des gepulsten Eingangssignals (HD) bestimmt wird und
Bestimmung der ungefähren Frequenz (fH) auf Basis der bestimmten Periode (TH).

7. Verfahren nach Anspruch 6,
bei dem, wenn die Differenz (z) zwischen dem verriegelten Wert (x) der gezählten Zyklen und dem Einstellzyklus (y) eine zweite Konstante (β) während wenigstens einer vorbestimmten Anzahl (M) aufeinanderfolgender Zyklen des durch N-dividierten Ausgangssignals (HDN) nicht kontinuierlich übersteigt, ein vorangegangener Wert der Frequenz (fH) des gepulsten Eingangssignals (HD) benutzt wird.

## Revendications

1. Détecteur de fréquence comprenant :
un moyen (17) pour produire un signal d'horloge cyclique de référence (F) ;
un moyen (15) pour recevoir un signal d'entrée (HD) ayant une fréquence (fH) à mesurer ;
un compteur (18) pour compter les cycles dudit signal d'horloge de référence (F) d'une manière répétitive pendant des intervalles de temps successifs dérivés dudit signal d'entrée ;
un moyen (22) pour établir un cycle de réglage (y) ; et,
un circuit de calcul (21), connecté audit compteur (18) et audit moyen (22) pour établir un cycle de réglage, pour ajouter ou soustraire une première constante (α) audit ou dudit cycle de réglage (y) en réponse à la différence (z) entre une valeur du compte (x) dudit compteur (18) et ledit cycle de réglage (y) ;
dans lequel, quand ladite différence (z) entre ladite valeur de compte (x) dudit compteur (18) et ledit cycle de réglage (y) dépasse une seconde constante (β) pendant un nombre prédéterminé (M) desdits intervalles successifs, ledit cycle de réglage (y) est réglé par le signal de sortie dudit circuit de calcul (21) et une valeur approximative d'un cycle dudit signal d'entrée (HD) est calculée, la fréquence approximative (fH) dudit signal d'entrée étant ainsi détectée.

2. Détecteur de fréquence selon la revendication 1, dans lequel, quand ladite différence (z) entre ladite valeur de compte (x) et ledit cycle de réglage (y) ne dépasse pas ladite seconde constante (β) d'une manière continue pendant au moins ledit nombre prédéterminé (M) d'intervalles, ledit cycle de réglage (y) n'est pas réglé, une protection étant ainsi obtenue contre un réglage prématuré dudit cycle de réglage (y) en réponse à des pertes d'impulsions ou à des fluctuations de la base de temps se produisant dans ledit signal d'entrée (HD).

3. Détecteur de fréquence selon la revendication 2, dans lequel ledit nombre prédéterminé (M) d'intervalles est une pluralité.

4. Détecteur de fréquence selon la revendication 3, dans lequel ledit nombre prédéterminé (M) d'intervalles est quatre.

5. Détecteur de fréquence selon la revendication 2, dans lequel :
ledit signal d'entrée (HD) est un signal pulsé d'entrée ;
ledit moyen (15) pour recevoir ledit signal d'entrée (HD) comprend un moyen pour diviser ledit signal d'entrée (HD) par N afin de produire un signal divisé par N de sortie (HDN) ;
lesdits intervalles successifs sont constitués par des cycles successifs respectifs dudit signal de sortie divisé par N (HDN), ledit compteur étant remis à zéro par des cycles successifs dudit signal divisé par N de sortie (HDN) ;
ledit détecteur de fréquence comprend un moyen (19) pour verrouiller la valeur des cycles comptés par ledit compteur (18) pendant lesdits cycles successifs dudit signal divise par N de sortie (HDN) ledit circuit de calcul (21) étant connecté audit moyen de verrouillage, ladite valeur de compte (x) étant la valeur verrouillée dudit compteur (18) ; et,
ledit calcul d'un cycle dudit signal d'entrée comprend le calcul de la période (TH) dudit signal pulsé d'entrée.

6. Procédé de détection de la fréquence (fH) d'un signal pulsé d'entrée (HD), le procédé comprenant les étapes qui consistent à :
produire un signal d'horloge de référence (F) d'une fréquence donnée (fCK) ;
recevoir ledit signal pulsé d'entrée (HD) et diviser ledit signal pulsé reçu par N pour produire un signal divisé par N de sortie (HDN) ;
compter les cycles dudit signal d'horloge de référence (F) pendant des cycles successifs dudit signal divisé par N de sortie (HDN) ;
verrouiller la valeur des cycles dudit signal d'horloge de référence (F) comptés pendant lesdits cycles successifs dudit signal divisé par N de sortie (HDN) ;
établir un cycle de réglage (y) ;
comparer la valeur verrouillée (x) des cycles comptés audit cycle de réglage (y) ;
ajouter ou soustraire une première constante (α) audit ou dudit cycle de réglage (y) en réponse à la différence (z) entre ladite valeur verrouillée (x) des cycles comptés et ledit cycle de réglage (y) ;
régler ledit cycle de réglage (y) selon ladite addition ou ladite soustraction quand la différence (z) entre ladite valeur verrouillée (x) et ledit cycle de réglage (y) dépasse une seconde constante (β) pendant un nombre prédéterminé (M) desdits cycles successifs dudit signal divisé par N de sortie (HDN), une valeur approximative de la période (TH) du signal pulsé d'entrée (HD) étant ainsi déterminée ; et à,
déterminer la fréquence approximative (fH) selon la période déterminée (TH)

7. Procédé selon la revendication 6, consistant, quand ladite différence (z) entre ladite valeur verrouillée (x) des cycles comptés et ledit cycle de réglage (y) ne dépasse pas ladite seconde constante (β) d'une manière continue pendant au moins ledit nombre prédéterminé (M) de cycles successifs dudit signal divisé par N de sortie (HDN), à utiliser une valeur précédente de la fréquence (fH) du signal pulsé d'entrée (HD).
